# EUROPEAN PATENT APPLICATION

(11) **EP 4 776 427 A1**
(43) Date of publication of application: **15.07.2026**
(21) Application number: 24863254.9
(22) Date of filing: 06.09.2024
(51) Int. Cl.: H01Q 1/38

(54) **ANTENNA SUBSTRATE AND ANTENNA MODULE COMPRISING SAME**

(30) Priority: 08.09.2023 KR 20230119694
(71) Applicant: LG Innotek Co., Ltd., Seoul 07796 (KR)
(72) Inventor: SONG, Tae Seop, Seoul 07796 (KR); LEE, In Jae, Seoul 07796 (KR); KEUM, Do Hee, Seoul 07796 (KR); JEONG, Ui Seok, Seoul 07796 (KR)
(74) Representative: DREISS Patentanwälte PartG mbB
(86) International application number: PCT/KR2024/013503
(87) International publication number: WO 2025/053675

(57) **Abstract**

An antenna substrate according to an embodiment includes an insulating layer; a metal pattern disposed on the insulating layer, wherein a first gap is provided between the metal pattern and the insulating layer, and wherein a height of the first gap is 0.1% to 10% of a thickness of the insulating layer.

## Description

### Technical Field

An embodiment relates to an antenna substrate and an antenna module including the same.

### Background Art

Recently, an improved 5G (5th generation) communication system or a pre-5G communication system has been developed to satisfy the demand for wireless data traffic.

For a high data transmission rate, the 5G communication system uses an ultra-high frequency (mmWave) band (6 GHz, 28 GHz, 38 GHz, or a frequency higher than the foregoing). These high frequency bands are referred to as mmWave due to a wavelength length.

In order to mitigate path loss of radio waves in an ultra-high frequency band and increase a transmission distance of radio waves, in the 5G communication system, integration technologies such as beamforming, massive MIMO, and array antenna have been developed.

Considering that hundreds of active antennas may be formed due to a wavelength in these frequency bands, an antenna system may be relatively increased in size.

This means that a plurality of substrates constituting an active antenna system, that is, an antenna substrate, an antenna feeding substrate, a transceiver substrate, and a baseband substrate, should be integrated as one compact unit.

The antenna substrate is formed in a multilayer structure. The antenna substrate is manufactured by bonding the multilayers by heat and pressure.

However, when the antenna substrate is exposed to a high-temperature and/or high-humidity environment, an adhesion force of the multilayers may be decreased. Accordingly, characteristics and reliability of the antenna substrate may be decreased.

Accordingly, a new-structure antenna substrate and an antenna module including the same, capable of solving the above problems, are required.

As a related prior art related to the antenna substrate, Korean Public Patent Application KR10-2021-0130192 is disclosed.

### Disclosure

### Technical Problem

An embodiment provides an antenna substrate and an antenna module having improved reliability and characteristics.

### Technical Solution

An antenna substrate according to an embodiment includes an insulating layer; a metal pattern disposed on the insulating layer, wherein a first gap is provided between the metal pattern and the insulating layer, and wherein a height of the first gap is 0.1% to 10% of a thickness of the insulating layer.

In addition, the insulating layer includes a first insulating layer; and a second insulating layer disposed on the first insulating layer, the metal pattern includes a first metal pattern disposed on the second insulating layer; and a second metal pattern disposed between the first insulating layer and the second insulating layer, and wherein the first gap is provided between the first insulating layer and the first metal pattern.

In addition, the antenna substrate further comprises a second gap provided between the first insulating layer and the second insulating layer, wherein a height of the second gap is 0.1% to 10% of a thickness of the first insulating layer.

In addition, a thickness of the first insulating layer is 25 µm to 150 µm.

In addition, a height of the first gap or the second gap is 0.1 µm to 10 µm.

In addition, the antenna substrate further comprises a via electrode penetrating the second insulating layer along a vertical direction; and a bonding layer disposed between the via electrode and the second metal pattern.

In addition, the bonding layer includes a copper-tin alloy.

In addition, at least one of an adhesion force between the first insulating layer and the second insulating layer and an adhesion force between the first insulating layer and the second metal pattern is 0.5 kgf to 1.5 kgf.

Meanwhile, an antenna substrate according to another embodiment comprises an insulating structure including a lower insulating layer, an inner insulating layer disposed on the lower insulating layer, and an upper insulating layer disposed on the inner insulating layer; and a metal pattern including an upper metal pattern disposed on the upper insulating layer, a first inner metal pattern disposed between the lower insulating layer and the inner insulating layer, and a second inner metal pattern disposed between the inner insulating layer and the upper insulating layer, wherein a gap is provided in at least one of between the lower insulating layer and the first inner metal pattern, between the inner insulating layer and the second inner metal pattern, between the lower insulating layer and the inner insulating layer, and between the inner insulating layer and the upper insulating layer, and wherein a height of the gap is 0.1% to 10% of a thickness of any one insulating layer among the lower insulating layer, the inner insulating layer, and the upper insulating layer.

In addition, the inner insulating layer includes a first inner insulating layer, and a second inner insulating layer disposed on the first inner insulating layer, and a thickness of the first inner insulating layer is different from a thickness of the second inner insulating layer.

In addition, the thickness of the first inner insulating layer is different from each thickness of the lower insulating layer and the upper insulating layer.

In addition, the thickness of the first inner insulating layer is greater than each thickness of the second inner insulating layer, the lower insulating layer, and the upper insulating layer.

In addition, the metal pattern further includes a third inner metal pattern disposed between the first inner insulating layer and the second inner insulating layer,
in addition, the gap includes a first gap provided between the lower insulating layer and the first inner metal pattern, a second gap disposed between the first inner insulating layer and the third inner metal pattern, and a third gap disposed between the second inner insulating layer and the upper insulating layer, and
in addition, a height of the second gap is different from a height of the first gap and a height of the third gap.

In addition, the height of the second gap is greater than the height of the first gap and the height of the third gap.

In addition, a variation of heights of the first gap to the third gap is 0.1% to 5% of a thickness of any one insulating layer among the lower insulating layer, the first inner insulating layer, the second inner insulating layer, and the upper insulating layer.

In addition, the variation is 0.1 µm to 5 µm.

### Advantageous Effects

The antenna substrate according to embodiments includes a plurality of insulating layers. The insulating layers are bonded by a thermocompression process. The thermocompression process is performed at a temperature, a pressure, and a time within a set range. In detail, the bonding temperature has a temperature similar to a melting point of the insulating layer. Accordingly, an adhesion force of the insulating layer may be increased. Accordingly, interlayer delamination of the antenna substrate is decreased, and interlayer adhesion is improved. Accordingly, signal loss of the antenna substrate according to embodiments is decreased.

In addition, even when the antenna substrate is exposed to a high-temperature and humid environment for a long time, an adhesion force of the insulating layer is maintained. Accordingly, driving characteristics of the antenna substrate do not change depending on a use environment.

Accordingly, driving characteristics and reliability of the antenna substrate according to embodiments are improved.

### Description of Drawings

FIG. 1 is a top plan view of an antenna substrate according to an embodiment.
FIG. 2 is a cross-sectional view obtained by cutting A-A' region of FIG. 1.
FIG. 3 is an enlarged view of B region of FIG. 2.
FIGS. 4 to 6 are views for describing a manufacturing process of an antenna substrate according to an embodiment.
FIG. 7 is an enlarged view of C region of FIG. 6.
FIGS. 8 to 12 are scanning electron microscope (SEM) photographs of an embodiment and a comparative example.
FIG. 13 is a cross-sectional view of an antenna package including an antenna substrate according to an embodiment.

### Modes of the Invention

Hereinafter, embodiments of the present disclosure will be described in detail with reference to the accompanying drawings. However, the spirit and scope of the present disclosure is not limited to a part of the embodiments described, and may be implemented in various other forms, and within the spirit and scope of the present disclosure, one or more of the elements of the embodiments may be selectively combined and redisposed.

In addition, unless expressly otherwise defined and described, the terms used in the embodiments of the present disclosure (including technical and scientific terms) may be construed the same meaning as commonly understood by one of ordinary skill in the art to which the present disclosure belongs, and the terms such as those defined in commonly used dictionaries may be interpreted as having a meaning that is consistent with their meaning in the context of the relevant art.

In addition, the terms used in the embodiments of the present disclosure are for describing the embodiments and are not intended to limit the present disclosure. In this specification, the singular forms may also include the plural forms unless specifically stated in the phrase, and may include at least one of all combinations that may be combined in A, B, and C when described in "at least one (or more) of A (and), B, and C".

Further, in describing the elements of the embodiments of the present disclosure, the terms such as first, second, A, B, (a), and (b) may be used. These terms are only used to distinguish the elements from other elements, and the terms are not limited to the essence, order, or order of the elements.

In addition, when an element is described as being "connected", "coupled", or "contacted" to another element, it may include not only when the element is directly "connected" to, "coupled" to, or "contacted" to other elements, but also when the element is "connected", "coupled", or "contacted" by another element between the element and other elements.

In addition, when described as being formed or disposed "on (over)" or "under (below)" of each element, the "on (over)" or "under (below)" may include not only when two elements are directly connected to each other, but also when one or more other elements are formed or disposed between two elements.

Further, when expressed as "on (over)" or "under (below)", it may include not only the upper direction but also the lower direction based on one element.

Hereinafter, an antenna substrate and a smart IC card including the same according to embodiments will be described with reference to the drawings.

An antenna substrate 1000 described below transmits a signal of a millimeter wavelength (mmWave) band. In detail, the antenna substrate 1000 transmits a signal of a high frequency band. For example, the antenna substrate 1000 may transmit a high frequency signal of 20 GHz or more, 20 GHz to 45 GHz, or 24 GHz to 41 GHz.

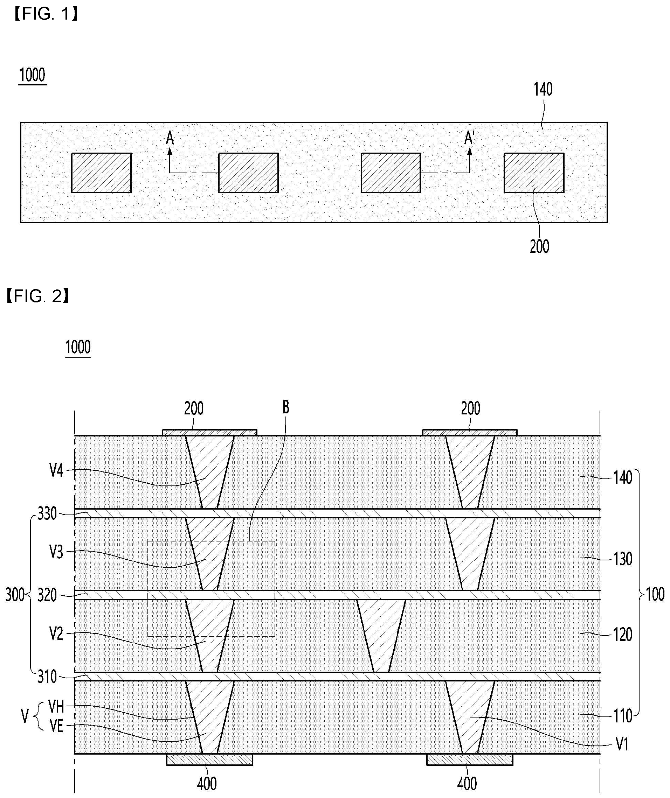

Referring to FIGS. 1 to 3, the antenna substrate 1000 includes an insulating layer 100, a first metal pattern 200, a second metal pattern 300, a via V, and a third metal pattern 400.

The insulating layer 100 includes a plurality of insulating layers. Accordingly, the antenna substrate 100 is formed as a multilayer antenna substrate 1000. For example, the insulating layer 100 may include a first insulating layer 110, a second insulating layer 120, a third insulating layer 130, and a fourth insulating layer 140. However, embodiments are not limited thereto. The insulating layer 100 may include five or more insulating layers. As an example, the insulating layer 100 may include eight insulating layers.

Hereinafter, for convenience of description, the insulating layer is described as including four insulating layers.

The first insulating layer 110 is a lowermost insulating layer. In addition, the fourth insulating layer 140 is an uppermost insulating layer. The second insulating layer 120 and the third insulating layer 130 are disposed between the first insulating layer 110 and the fourth insulating layer 140. In detail, the second insulating layer 120 is disposed on the first insulating layer 110. In addition, the third insulating layer 130 is disposed on the second insulating layer 120. In addition, the fourth insulating layer 140 is disposed on the third insulating layer 130.

The insulating layer 100 includes a resin material. For example, the insulating layer 100 may include a resin material whose physical characteristics change depending on temperature. For example, the insulating layer 100 may include a thermoplastic resin. Accordingly, the insulating layers 110, 120, 130, and 140 may be thermocompression-bonded at a temperature and a pressure within a set range.

For example, the insulating layer 100 includes a liquid crystal polymer (LCP). The liquid crystal polymer is a material having both characteristics of a liquid state and a solid state. That is, the liquid crystal polymer has a regular crystal orientation like a solid state even in a liquid state.

The insulating layer 100 has a thickness within a set range. For example, a thickness of the insulating layer 100 may be 150 µm or less. In more detail, the thickness of the insulating layer 100 may be 25 µm to 150 µm, 25 µm to 130 µm, or 75 µm to 110 µm.

If the thickness of the insulating layer 100 is less than 25 µm, a large number of layers may be required to manufacture the antenna substrate. Accordingly, process efficiency is decreased. If the thickness of the insulating layer 100 exceeds 150 µm, a size of the via V may be increased. Accordingly, impedance of a high frequency signal passing through the via V may be mismatched and discontinuous impedance may occur. Accordingly, since transmission loss of a signal having a frequency within a set range is increased, performance of the antenna substrate is decreased.

A thickness of any one insulating layer among the plurality of insulating layers may be different from a thickness of another insulating layer. For example, a thickness of the second insulating layer 120 or the third insulating layer 130 may be different from thicknesses of other insulating layers. For example, the thickness of the second insulating layer 120 may be greater than thicknesses of other insulating layers. That is, the second insulating layer 120 may be a core layer.

The insulating layer 100 has a dielectric constant (Dk) within a set range. In detail, the insulating layer 100 has a dielectric constant of 3.2 or less. Accordingly, transmission loss of a high frequency signal transmitted through the antenna substrate is decreased.

The first metal pattern 200 is disposed on an uppermost insulating layer. In detail, the first metal pattern 200 is disposed on the fourth insulating layer 140. The first metal pattern 200 may include at least one metal among gold (Au), silver (Ag), platinum (Pt), titanium (Ti), tin (Sn), copper (Cu), zinc (Zn), and alloys thereof. Preferably, the first metal pattern 200 includes copper (Cu).

The first metal pattern 200 is a receiving portion of the antenna substrate 1000. That is, the antenna substrate 1000 receives a signal in a set frequency band range.

The first metal pattern 200 is formed in various shapes. For example, the first metal pattern 200 may be formed in a quadrangular shape, a triangular shape, a circular shape, or an octagonal shape.

The second metal pattern 300 is disposed between the insulating layers. In detail, the second metal pattern is disposed on each of the insulating layers. In detail, the second metal pattern 300 includes a second-first metal pattern 310, a second-second metal pattern 320, and a second-third metal pattern 330. The second-first metal pattern 310 is disposed on the first insulating layer 110. The second-second metal pattern 320 is disposed on the second insulating layer 120. The second-third metal pattern 330 is disposed on the third insulating layer 130.

The second metal pattern 300 may include at least one metal among gold (Au), silver (Ag), platinum (Pt), titanium (Ti), tin (Sn), copper (Cu), zinc (Zn), and alloys thereof. The second metal pattern 300 may include the same metal as the first metal pattern 200. Preferably, the second metal pattern 300 includes copper (Cu).

The second metal pattern 300 transmits a signal received from the first metal pattern 200. The second metal pattern 300 is a wiring pattern transmitting a signal. That is, the second metal pattern 300 is a transmission line transmitting a signal in the antenna substrate 1000.

The via V includes a via hole VH and a via electrode VE.

The via hole VH is formed to penetrate the insulating layer 100. At least one via hole VH may be formed in each of the insulating layers 110, 120, 130, and 140.

The via electrode VE is disposed inside the via hole VH. The via electrode VE may include the same material as the first metal pattern 200 and the second metal pattern 300. For example, the via electrode VE may include copper.

By the via V, second metal layers disposed on different layers are electrically connected. Accordingly, a signal received by the first metal pattern 200 may be transmitted to an external component. In detail, a signal received from the first metal pattern 200 is transmitted to the second metal pattern 300 by the via V. In addition, the signal moves through the second metal pattern 300 and is transmitted to the third metal pattern 400 disposed on the fourth insulating layer 140 which is a lowermost insulating layer. Accordingly, the signal is transmitted to an external electronic component connected to the antenna substrate by the third metal pattern 400.

A bonding region is formed between the second metal pattern 300 and the via V. For example, a bonding layer CL is disposed between the second metal pattern 300 and the via V. The insulating layers and the insulating layer and the second metal pattern are bonded by a thermocompression process. However, the second metal pattern 300 and the via V are not bonded by the thermocompression process. Accordingly, the bonding layer CL may bond the second metal pattern 300 and the via V.

The bonding layer CL may include tin. In detail, the bonding layer CL may include a copper-tin alloy. For example, the bonding layer CL may include a Cu₃Sn alloy.

As described above, the insulating layers are bonded by the thermocompression process. However, depending on conditions of the thermocompression process, bonding strength of the insulating layer may be change. Alternatively, when the antenna substrate is exposed to a high-temperature and/or humid environment, bonding strength of the insulating layer may be change. Accordingly, bonding strength of the insulating layers may be decreased. Alternatively, bonding strength between the insulating layer and the second metal pattern may be decreased.

Accordingly, reliability and driving characteristics of the antenna substrate may be decreased.

The antenna substrate 1000 according to embodiments controls conditions of the thermocompression process. Accordingly, bonding strength of the insulating layer may be optimized. Accordingly, a gap of the insulating layers or a gap between the insulating layer and the second metal pattern may be minimized.

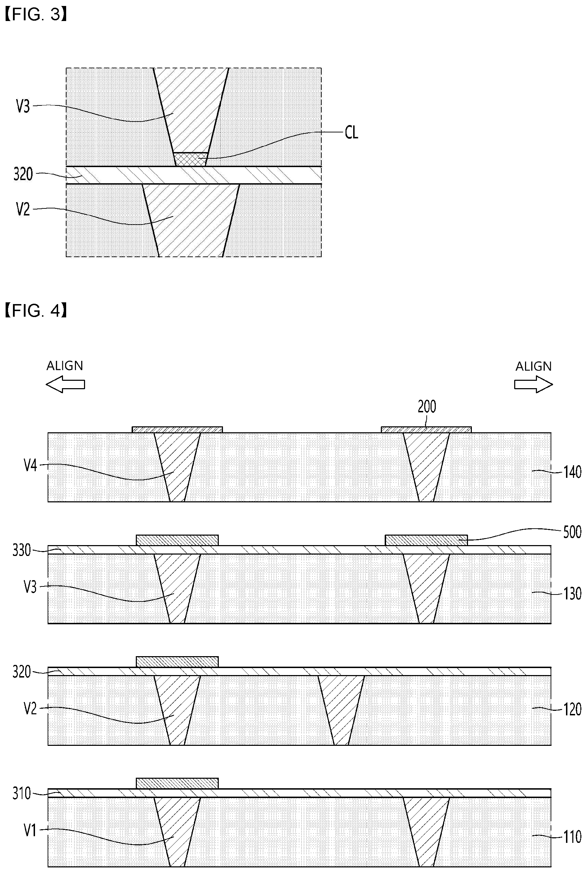

FIGS. 4 to 6 are views for describing a manufacturing process of the antenna substrate.

Referring to FIG. 4, first, each insulating layer is prepared. In detail, the first insulating layer 110, the second insulating layer 120, the third insulating layer 130, and the fourth insulating layer 140 are prepared.

The second metal patterns 310, 320, and 330 are disposed on the first insulating layer 110, the second insulating layer 120, and the third insulating layer 130. In addition, the first metal pattern 200 is disposed on the fourth insulating layer 140. The first metal pattern 200 is disposed on the via V4.

A bonding metal 500 is disposed on at least one via among the plurality of vias V. The bonding metal 500 is disposed on the second metal pattern 300. In detail, the bonding metal 500 is disposed on a region where the vias V are connected.

The bonding metal 500 may include a material capable of bonding the via and the second metal pattern 300. For example, the bonding metal 500 may include tin (Sn).

Subsequently, the insulating layers are aligned. Accordingly, positions of the vias V1, V2, V3, and V4 may be aligned.

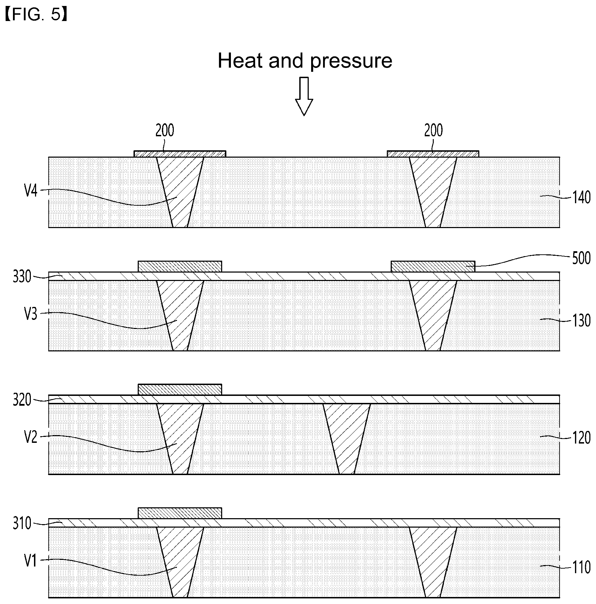

Subsequently, referring to FIG. 5, the insulating layers are bonded. The insulating layers are bonded by a thermocompression process. In detail, the bonding layers are bonded by heat and pressure within a set range.

A bonding temperature, a bonding pressure, and a bonding time of the thermocompression process may be controlled. Accordingly, adhesion force of the insulating layer may be optimized.

The bonding temperature has a magnitude within a set range. The bonding temperature may be similar to a melting point of the insulating layer. For example, when the insulating layer 100 includes a liquid crystal polymer material, the bonding temperature may be similar to a melting point of the liquid crystal polymer material.

For example, the bonding temperature may exceed 300°C. In detail, the bonding temperature may be more than 300°C and 315°C. In more detail, the bonding temperature may be 305°C to 313°C or 308°C to 311°C.

The bonding pressure has a magnitude within a set range. For example, the insulating layer 100 may include a liquid crystal polymer material. In this case, the bonding pressure may be 35 MPa to 45 MPa, 37 MPa to 43 MPa, or 39 MPa to 41 MPa.

The bonding time has a magnitude within a set range. For example, the insulating layer 100 may include a liquid crystal polymer material. In this case, the bonding time may be 25 minutes to 35 minutes, 27 minutes to 33 minutes, or 29 minutes to 31 minutes.

Under conditions of the bonding temperature, the bonding pressure, and the bonding time, optimal bonding strength of the insulating layer may be obtained. Accordingly, interlayer adhesion force of the antenna substrate may be increased. In detail, interlayer adhesion force of the antenna substrate may be 0.5 kgf or more. In more detail, interlayer adhesion force of the antenna substrate may be 0.5 kgf to 1.5 kgf, 0.8 kgf to 1.4 kgf, or 1.0 kgf to 1.3 kgf.

The interlayer adhesion force may be measured by an adhesion test. In detail, before thermocompression-bonding the insulating layers, a specimen is inserted into any one region among inter-regions between the insulating layers. Subsequently, after bonding the insulating layers, a force required to remove the specimens is measured. The interlayer adhesion force is a value calculated as an average by repeating the above steps several times.

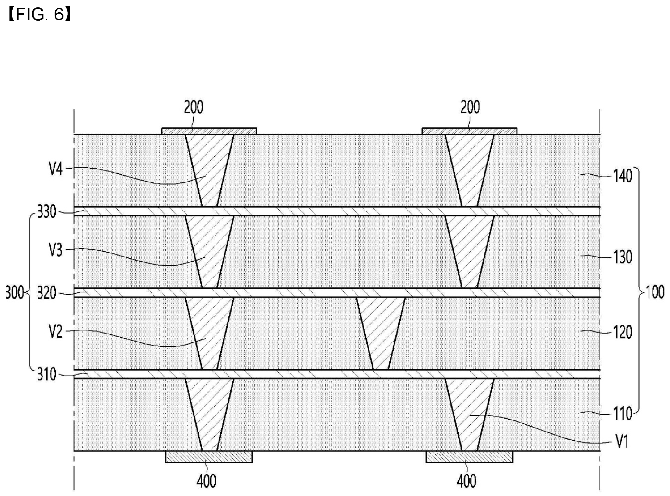

Referring to FIG. 6, the insulating layers are bonded by the thermocompression process. Subsequently, the third metal pattern 400 is disposed on the first insulating layer 110. The third metal pattern is disposed on the via V1. The antenna substrate 1000 is connected to another electronic component by the third metal pattern 400. For example, the antenna substrate 1000 may be connected to a chip or a printed circuit board.

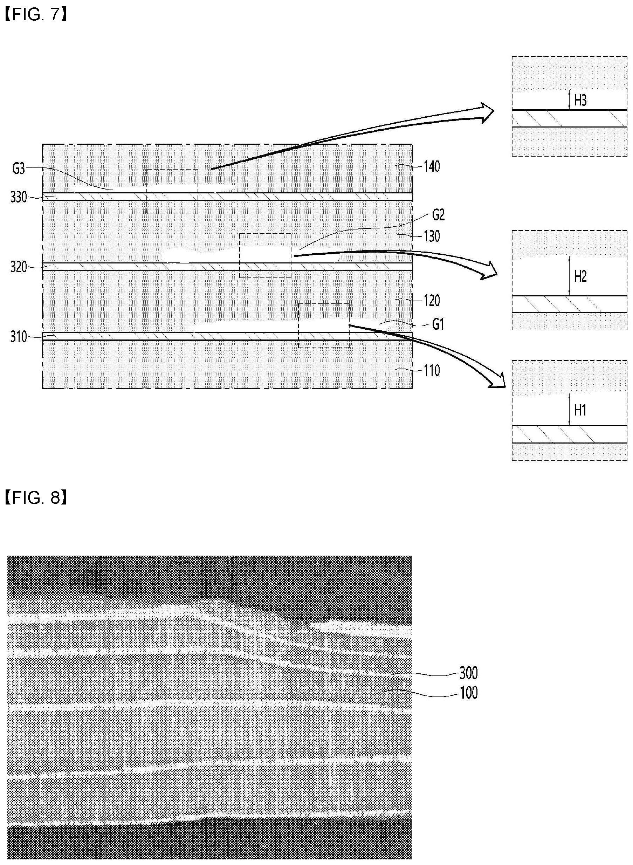

Referring to FIG. 7, a gap may be formed between the insulating layer and the second metal pattern. In detail, a first gap G1 is formed between the second-first metal pattern 310 and the second insulating layer 120. In addition, a second gap G2 is formed between the second-second metal pattern 320 and the third insulating layer 130. In addition, a third gap G3 is formed between the second-third metal pattern 330 and the fourth insulating layer 140.

A size of the gaps G1, G2, and G3 may be controlled. In detail, the temperature, the pressure, and the time of the thermocompression process are controlled. Accordingly, adhesion force of the insulating layer is improved. Accordingly, the sizes of the gaps G1, G2, and G3 may be controlled to be within a set range.

The gaps G1, G2, and G3 each have heights H1, H2, and H3. The heights H1, H2, and H3 are defined as maximum heights. The heights H1, H2, and H3 may be sizes of the gaps G1, G2, and G3. The heights H1, H2, and H3 may be equal to or less than the thickness of the insulating layer. In detail, the heights H1, H2, and H3 may be 10% or less of the thickness of the insulating layer. In more detail, the heights H1, H2, and H3 may be 0.1% to 10%, 0.5% to 5%, or 1% to 3% of the thickness of the insulating layer.

For example, the heights H1, H2, and H3 may be 10 µm or less. In detail, the heights H1, H2, and H3 may be 10 µm or less. In more detail, the heights H1, H2, and H3 may be 0.1 µm to 10 µm, 0.5 µm to 5 µm, or 1 µm to 3 µm.

When the heights H1, H2, and H3 exceed the above ranges, transmission loss of the antenna substrate may be increased. In addition, external impurities may enter through the gaps. Accordingly, reliability of the antenna substrate may be decreased.

A size of any one gap among the gaps G1, G2, and G3 may be different from a size of another gap. For example, a size of the second gap G2 may be greater than a size of the first gap G1 and a size of the third gap G3. The second insulating layer 120 may be a core layer. Accordingly, a thickness of the second insulating layer 120 may be greater than a thickness of another insulating layer. Accordingly, the size of the second gap G2 may be formed to be greatest. However, since bonding strength of the insulating layer is optimized, the size of the second gap G2 may be controlled to be within the above range.

The first gap G1, the second gap G2, and the third gap G3 have a variation within a set range. In detail, a variation of the first gap G1, the second gap G2, and the third gap G3 may be 5% or less of the thickness of the insulating layer. In more detail, the variation may be 0.1% to 5%, 0.5% to 4%, or 1% to 2% of the thickness of the insulating layer.

For example, a variation of the first gap G1, the second gap G2, and the third gap G3 may be 0.1 µm to 5 µm, 0.5 µm to 4 µm, or 1 µm to 2 µm.

Since adhesion force of the insulating layer is increased, a size of a gap of each layer is decreased. Accordingly, a variation of a gap of the insulating layers is also decreased.

Accordingly, transmission loss of a signal moving through each layer may be decreased.

Hereinafter, adhesion characteristics of an antenna substrate according to conditions of a thermocompression process will be described through an embodiment and comparative examples.

### Experimental Example 1

Antenna substrates of an embodiment and comparative examples are manufactured by the following process.

A plurality of insulating layers are prepared. The insulating layer is a liquid crystal polymer material (LCP). A copper layer is disposed on each of the insulating layers.

Subsequently, a via is formed in each insulating layer, and the via includes copper.

Subsequently, tin is disposed on a copper layer corresponding to the via.

Subsequently, a plurality of insulating layers are bonded using a pressing equipment.

Process conditions of the pressing equipment are as shown in Table 1.

Subsequently, a degree of delamination (gap) and an interlayer adhesion force of Embodiment 1 and Comparative Examples 1 and 2 were measured.

The degree of delamination measured delamination between an insulating layer and copper.

The interlayer adhesion force measured adhesion force between insulating layers and adhesion force between an insulating layer and the second metal pattern.

**[TABLE 1]**

| | Embodiment 1 | Comparative Example 1 | Comparative Example 2 |
|---|---|---|---|
| Temperature (°C | 310 | 290 | 300 |
| Pressure (MPa) | 30 | 30 | 30 |
| Time (min) | 4 | 4 | 4 |

**[TABLE 2]**

| | Embodiment 1 | Comparative Example 1 | Comparative Example 2 |
|---|---|---|---|
| Degree of delamination (µm) | 0.1 | 50 | 20 |
| Interlayer adhesion force (kgf) | 1.25 | 0.61 | 0.48 |

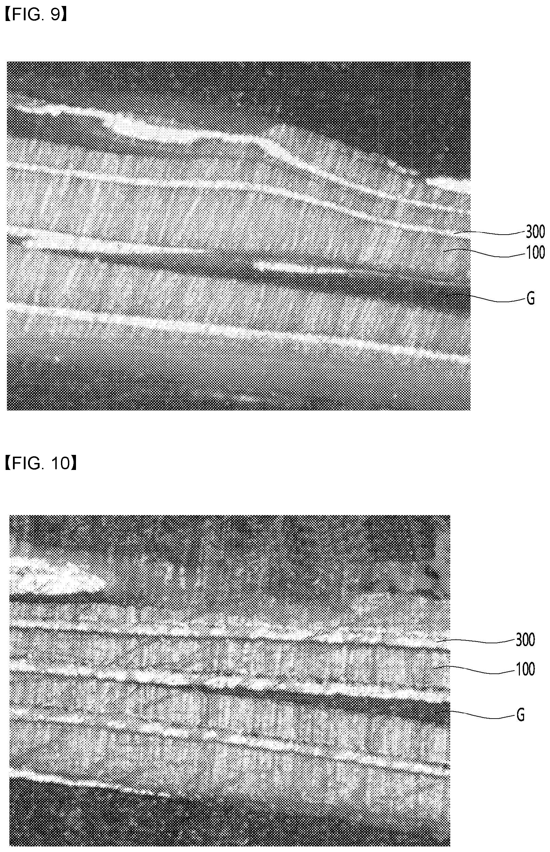

Referring to Table 1, Table 2, and FIGS. 8 to 10, in Embodiment 1, a bonding temperature is almost similar to a melting point of an insulating layer. In addition, it can be seen that in Embodiment 1, a gap between an insulating layer and copper is very small. That is, since the bonding temperature is almost similar to the melting point of the insulating layer, it can be seen that adhesion force of the insulating layer is increased.

On the other hand, in Comparative Example 1 and Comparative Example 2, a bonding temperature is different from the melting point of the insulating layer, that is, the bonding temperature is different from the melting point of the insulating layer by 10°C or more. In addition, it can be seen that in Comparative Example 1 and Comparative Example 2, a gap between an insulating layer and copper is very large. That is, since the bonding temperature is different from the melting point of the insulating layer, it can be seen that adhesion force of the insulating layer is decreased.

### Experimental Example 2

Insulating layers are bonded by the same method as in Experimental Example 1. In detail, eight insulating layers are bonded by thermocompression.

Subsequently, a highly accelerated stress test (HAST) is performed. The HAST is performed under conditions of a temperature of 130°C, a humidity of 85%, and a pressure of 230 kPa. Antenna substrates of Embodiment 2 and Comparative Example 3 are exposed under the conditions for 196 hours.

Subsequently, a degree of delamination (gap) and an interlayer adhesion force of Embodiment 1 and Comparative Examples 1 and 2 were measured.

The degree of delamination measured delamination between an insulating layer and copper.

The interlayer adhesion force measured adhesion force between insulating layers and adhesion force between an insulating layer and the second metal pattern.

**[TABLE 3]**

| | Embodiment 1 | Comparative Example 3 |
|---|---|---|
| Degree of delamination (µm) | 0.1 | 100 |
| Interlayer adhesion force (kgf) | 1.25 | 0.38 |

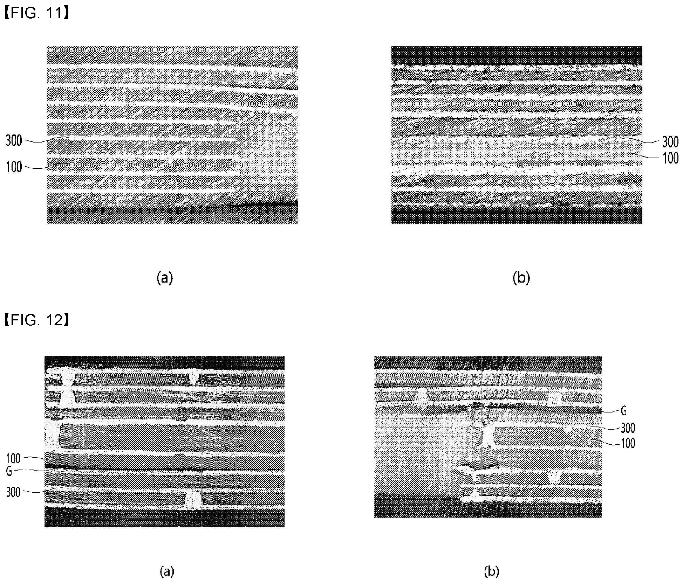

Referring to Table 3, FIG. 11, and FIG. 12, it can be seen that in the antenna substrate of Embodiment 2, after the HAST, the degree of delamination and the interlayer adhesion force are maintained. In Embodiment 2, a bonding temperature is almost similar to a melting point of an insulating layer. That is, since the bonding temperature is almost similar to the melting point of the insulating layer, it can be seen that adhesion force of the insulating layer is increased.

Accordingly, it can be seen that even when the antenna substrate is exposed to a high-temperature and humid environment for a long time, adhesion force of the insulating layer is maintained.

On the other hand, it can be seen that in the antenna substrate of Comparative Example 3, after the HAST, the degree of delamination is increased. In addition, it can be seen that in the antenna substrate of Comparative Example 3, after the HAST, the interlayer adhesion force is decreased. In Comparative Example 3, a bonding temperature is different from the melting point of the insulating layer, that is, the bonding temperature is different from the melting point of the insulating layer by 10°C or more. That is, due to a difference between the bonding temperature and the melting point of the insulating layer, it can be seen that adhesion force of the insulating layer is decreased.

Accordingly, it can be seen that when the antenna substrate is exposed to a high-temperature and humid environment for a long time, adhesion force of the insulating layer is decreased.

In addition, by the structure as described above, names of each insulating layer and names of metal patterns may be referred to differently.

Accordingly, an antenna substrate according to embodiments includes an insulating layer; and a metal pattern disposed on the insulating layer, and a first gap is provided between the metal pattern and the insulating layer, and a height of the first gap is 0.1% to 10% of a thickness of the insulating layer.

Further, the insulating layer includes a first insulating layer; and a second insulating layer disposed on the first insulating layer, and the metal pattern includes a first metal pattern disposed on the second insulating layer, and a second metal pattern disposed between the first insulating layer and the second insulating layer, and the first gap is provided between the first insulating layer and the first metal pattern.

Further, a second gap is provided between the first insulating layer and the second insulating layer, and a height of the second gap is 0.1% to 10% of a thickness of the first insulating layer.

Further, a thickness of the first insulating layer is 25 µm to 150 µm.

Further, a height of the first gap or the second gap is 0.1 µm to 10 µm.

Further, the antenna substrate further includes a via electrode penetrating the second insulating layer along a vertical direction; and a bonding layer disposed between the via electrode and the second metal pattern.

Further, the bonding layer includes a copper-tin alloy.

Further, at least one of an adhesion force between the first insulating layer and the second insulating layer and an adhesion force between the first insulating layer and the second metal pattern is 0.5 kgf to 1.5 kgf.

Meanwhile, an antenna substrate according to another embodiment includes an insulating structure including a lower insulating layer, an inner insulating layer disposed on the lower insulating layer, and an upper insulating layer disposed on the inner insulating layer; and a metal pattern including an upper metal pattern disposed on the upper insulating layer, a first inner metal pattern disposed between the lower insulating layer and the inner insulating layer, and a second inner metal pattern disposed between the inner insulating layer and the upper insulating layer, and a gap is provided in at least one of between the lower insulating layer and the first inner metal pattern, between the inner insulating layer and the second inner metal pattern, between the lower insulating layer and the inner insulating layer, and between the inner insulating layer and the upper insulating layer, and a height of the gap is 0.1% to 10% of a thickness of any one insulating layer among the lower insulating layer, the inner insulating layer, and the upper insulating layer.

Further, the inner insulating layer includes a first inner insulating layer, and a second inner insulating layer disposed on the first inner insulating layer, and a thickness of the first inner insulating layer is different from a thickness of the second inner insulating layer.

Further, the thickness of the first inner insulating layer is different from each thickness of the lower insulating layer and the upper insulating layer.

Further, the thickness of the first inner insulating layer is greater than each thickness of the second inner insulating layer, the lower insulating layer, and the upper insulating layer.

Further, the metal pattern further includes a third inner metal pattern disposed between the first inner insulating layer and the second inner insulating layer,
further, the gap includes a first gap provided between the lower insulating layer and the first inner metal pattern, a second gap disposed between the first inner insulating layer and the third inner metal pattern, and a third gap disposed between the second inner insulating layer and the upper insulating layer, and
further, a height of the second gap is different from a height of the first gap and a height of the third gap.

Further, the height of the second gap is greater than the height of the first gap and the height of the third gap.

Further, a variation of a height of the first gap to the third gap is 0.1% to 5% of a thickness of any one insulating layer among the lower insulating layer, the first inner insulating layer, the second inner insulating layer, and the upper insulating layer.

Further, the variation is 0.1 µm to 5 µm.

The antenna substrate according to embodiments includes a plurality of insulating layers. The insulating layers are bonded by a thermocompression process. The thermocompression process is performed at a temperature, a pressure, and a time within a set range. In detail, the bonding temperature has a temperature similar to a melting point of the insulating layer. Accordingly, adhesion force of the insulating layer may be increased. Accordingly, interlayer delamination of the antenna substrate is decreased, and interlayer adhesion is improved. Accordingly, signal loss of the antenna substrate according to embodiments is decreased.

Further, even when the antenna substrate is exposed to a high-temperature and humid environment for a long time, adhesion force of the insulating layer is maintained. Accordingly, driving characteristics of the antenna substrate do not change depending on a use environment.

Accordingly, driving characteristics and reliability of the antenna substrate according to embodiments are improved.

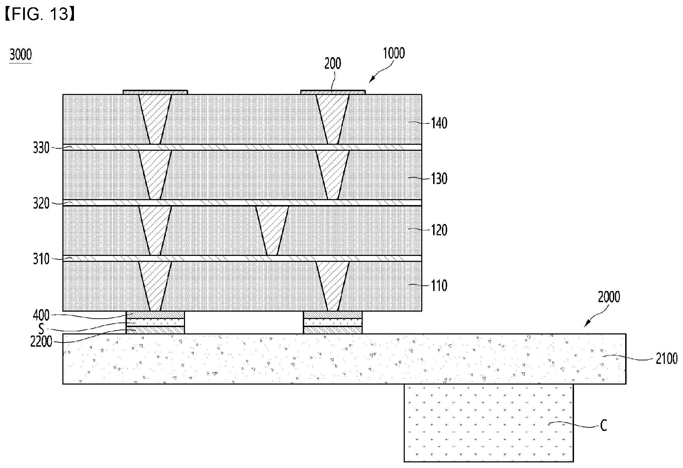

Hereinafter, an antenna module according to embodiments will be described with reference to FIG. 13.

Referring to FIG. 13, the antenna module includes the antenna substrate. In detail, the antenna module 3000 includes an antenna substrate 1000 and a printed circuit board 2000.

The printed circuit board 2000 includes a circuit board 2100 and a chip C disposed on the circuit board 2100. For example, the circuit board 2100 may include a rigid printed circuit board (PCB) or a flexible printed circuit board (FPCB). In addition, the chip C includes an RF chip.

The antenna substrate 1000 is connected to the chip package 2000. In detail, solder S is disposed between the third metal pattern 400 of the antenna substrate 1000 and a pad part 2200 of the printed circuit board 2000. Subsequently, by applying heat, the antenna substrate 1000 and the chip package 2000 are connected.

In the drawings, it is illustrated that the antenna substrate and the printed circuit board are connected, but embodiments are not limited thereto. For example, the antenna substrate may be connected to the chip. In detail, the third metal pattern 400 and a terminal of the chip may be directly connected.

The characteristics, structures and effects described in the embodiments above are included in at least one embodiment but are not limited to one embodiment. Furthermore, the characteristics, structures, and effects and the like illustrated in each of the embodiments may be combined or modified even with respect to other embodiments by those of ordinary skill in the art to which the embodiments pertain. Thus, it should be construed that contents related to such a combination and such a modification are included in the scope of the embodiment.

The description has been focused on the embodiment, but it is merely illustrative and does not limit the embodiment. A person skilled in the art to which the embodiment pertains may appreciate that various modifications and applications not illustrated above are possible without departing from the essential features of the embodiment. For example, each component particularly represented in the embodiment may be modified and implemented. In addition, it should be construed that differences related to such changes and applications are included in the scope of the embodiment defined in the appended claims.

## Claims

1. An antenna substrate comprising:
an insulating layer;
a metal pattern disposed on the insulating layer,
wherein a first gap is provided between the metal pattern and the insulating layer, and
wherein a height of the first gap is 0.1% to 10% of a thickness of the insulating layer.

2. The antenna substrate of claim 1, wherein the insulating layer includes a first insulating layer; and a second insulating layer disposed on the first insulating layer,
wherein the metal pattern includes:
a first metal pattern disposed on the second insulating layer; and
a second metal pattern disposed between the first insulating layer and the second insulating layer, and
wherein the first gap is provided between the first insulating layer and the first metal pattern.

3. The antenna substrate of claim 2, further comprising:
a second gap provided between the first insulating layer and the second insulating layer,
wherein a height of the second gap is 0.1% to 10% of a thickness of the first insulating layer.

4. The antenna substrate of claim 3, wherein a thickness of the first insulating layer is 25 µm to 150 µm.

5. The antenna substrate of claim 3, wherein a height of the first gap or the second gap is 0.1 µm to 10 µm.

6. The antenna substrate of claim 3, further comprising:
a via electrode penetrating the second insulating layer along a vertical direction; and
a bonding layer disposed between the via electrode and the second metal pattern.

7. The antenna substrate of claim 6, wherein the bonding layer includes a copper-tin alloy.

8. The antenna substrate of claim 3, wherein at least one of an adhesion force between the first insulating layer and the second insulating layer and an adhesion force between the first insulating layer and the second metal pattern is 0.5 kgf to 1.5 kgf.

9. An antenna substrate comprising:
an insulating structure including a lower insulating layer, an inner insulating layer disposed on the lower insulating layer, and an upper insulating layer disposed on the inner insulating layer; and
a metal pattern including an upper metal pattern disposed on the upper insulating layer, a first inner metal pattern disposed between the lower insulating layer and the inner insulating layer, and a second inner metal pattern disposed between the inner insulating layer and the upper insulating layer,
wherein a gap is provided in at least one of between the lower insulating layer and the first inner metal pattern, between the inner insulating layer and the second inner metal pattern, between the lower insulating layer and the inner insulating layer, and between the inner insulating layer and the upper insulating layer, and
wherein a height of the gap is 0.1% to 10% of a thickness of any one insulating layer among the lower insulating layer, the inner insulating layer, and the upper insulating layer.

10. The antenna substrate of claim 9, wherein the inner insulating layer includes a first inner insulating layer, and a second inner insulating layer disposed on the first inner insulating layer, and
wherein a thickness of the first inner insulating layer is different from a thickness of the second inner insulating layer.
